# EUROPEAN PATENT APPLICATION

(11) **EP 1 278 237 A1**
(43) Date of publication of application: **22.01.2003**
(21) Application number: 01870158.1
(22) Date of filing: 17.07.2001
(51) Int. Cl.: H01L 21/311

(54) **Method for residue removal on ferroelectric materials**

(71) Applicant: INTERUNIVERSITAIR MICROELEKTRONICA CENTRUM VZW, 3001 Leuven (BE)
(72) Inventor: Paraschiv, Vasile, 3000 Leuven (BE)
(74) Representative: Van Malderen, Joelle

(57) **Abstract**

The present invention is related to a method for residue removal after dry etching on a substrate coated with a ferroelectric material, such as a SBT or a Nb doped SBT material, with an etch gas composition comprising an immersion in an HCl solution comprising at least a dissolved NH₄F salt and a rinsing step.

## Description

### Field of the invention

The present invention is situated in the field of micro-electronics, and specifically related to a cleaning method of residues such as side wall polymers on ferro-electric components.

### State of the art

Ferroelectric materials are one of the most promising option for use in non-volatile memories. The unique properties of the Ferroelectric Random Access Memory (FRAM) like storing data in the absence of power, small DRAM-like cell size, low operating voltages and fast read and write, make them suitable in various areas like portable applications, logic integrated circuits (IC), smart cards, etc. All these fields require the highest performance and power efficiency.

The ferroelectric effect comes from the ability of the material to store an electric polarisation in the absence of an applied electric field. The data are stored within a crystalline structure and not like a charge as in the case of DRAM. This specific ability comes from the crystal structure able to maintain two stable states, a state 1 and a state 0 .

The simplest ferroelectric device is the ferroelectric capacitor (FECAP), which typically consist of two electrodes parallel to the substrate, containing the ferroelectric material sandwiched in between.

One of the most important classes of ferroelectric materials belongs to the so called Aurellius type of materials, of which Strontium-bismuth-tantalate, SrBi₂Ta₂O₉, or Nb doped Strontium-bismuth-tantalate in the following description called SBT, or Nb doped SET is a well known example in the art.

For device applications, it is useful to produce ferroelectric materials in the form of thin films to exploit the design flexibility of thin film geometries.

Ferroelectric thin films can be made by metal organic deposition (MOD) or by metal organic chemical vapor deposition (MOCVD).

However the device fabrication, that include in its structure the ferroelectric materials, is manly done by a pattern technology. According with actual demands for high density FRAM technologies, the cell size is shrinking more and more, favouring a size reduction of the capacitor and higher requirements regarding the critical dimensions of the steep etch profile.

The standard procedure used to produce this complex shaped cells, use a "mask" layer to create the right pattern. The overlying layer can also be used as a "hard mask", and the underlying layers can be etched to have about the same configuration as the "mask".

This is achieved via a lithographic process, where a sensitive polymer film is coated on top of the other film layers to be patterned, dried and exposed with the appropriate geometrical patterns through a photomask to an activating radiation.

In the following step, the substrate holding the film is soaked in a solution where the photosensitive material is developed. Depending on the type of the polymer used, either exposed or non-exposed areas of the polymer film are removed in the developing process.

Pattern transfer from the masking layer to the substrate is one of the key processes in the fabrication of microelectronics. This is generally known as etching process.

Etching processes can be roughly classified in wet and dry etching. Each technology has specific advantages and inconvenients.

Conventionally, the wet etching has been achieved using chemically reactive liquid to etch the substrate not covered by the mask. Wet etching can achieve a high selectivity but, as a pure chemical reaction, has no preferential direction (isotropic), which means that it attacks equally in each direction and undercuts the mask.

The etching chemicals start to attack the sidewalls as soon as some vertical etching occurs. This leads to poor line width control and limited resolution and is not optimal for complex patterning.

Sometimes, bubbles grow during the etch process and act as a mask, resulting in high nonuniformity.

On the other hand, dry etching techniques comprise a whole class of plasma-etching processes that use plasmas in form of low-pressure gas discharges to accomplish rapid rates of etching, high resolution for complex configurations, and good selectivity.

The etching medium is mainly a mixture of neutrals and a flux of ions oriented in a direction normal to the surface, which leads to an anisotropic etching. In other words, an energetic stream of ions bombards the exposed surface. This avoids an undesirable etching of the underlying materials and provides a very uniform etching.

Within the dry etching technology, the high density plasma is often proposed for patterning the SBT or the Nb doped SBT films because it exhibits superior directional etching, critical dimension control, and compatibility with the other dry processes such as chemical vapour deposition, sputtering, molecular beam epytaxy, etc.

To select reactive gases, several factors should be considered; the reactivity of the species created in the plasmas with the film, the volatility of the possible etch products, the selectivity towards other layers and the environmental impact of the gases.

Nevertheless all dry etching methods, including ion-mill etching, ionised gas and plasma etching have the disadvantage to create side wall polymers on the etched structure.

The composition and the amount of the etching residues are strongly dependent of the etching gases used during the dry etching process.

Prior art tried to select etching gas compositions leaving the ferroelectric materials free of residues. Unfortunately no satisfactory results has been obtained yet.

The requirements for the actual technologies like CD, profile, slope, selectivity strictly control and clean side walls makes it extremely difficult to find a composition that solves all the above mentioned problems.

The post etch cleaning process is very complex, due to the fact that the composition of these polymers are unknown, more than this, besides the chemical compositions, the deposition process related to the plasma parameters (power, bias, pressure, temperature) influence strongly the residue properties.

Cuchiaro discloses in EP-A-0951058 a method of fabricating ferroelectric integrated circuits using dry and wet etching, to remove the hydrogen barrier layer, in a ferroelectric integrated circuit.

The first etch step is a dry etch which rapidly removes most of the hydrogen barrier layer. The second step is a wet chemical etch using a solution containing NH₄OH, H₂O₂ and H₂O, that selectively removes the remains of the barrier.

The remaining free Ti is oxidised to various Titanoxydes which weakens the TiN structure and makes it washable with NH₄OH.

No comments about previous steps and possible cleaning procedures have been made and the method does not satisfy the latest critereas of post-etch cleaning in terms of total contamination free structures.

Yoshihisa, Yasuhiro & Eiji in JP 2000-004010 teaches a dry etching with a washing step where the deposited reaction products on the side walls are removed in an inert gas atmosphere, such as H, Ar, He, or by solutions containing water, hydrochloric acid, nitric acid, fluoric acid or organic solvents. This document does not teach any precise compositions of the cleaning solutions, immersion times, concentrations or selectivity towards substrates.

Yoon, Tokumitsu and Ishiwara teaches in Electronic device letters, Vol.20, NO. 10, October 1999, a wet etching of SBT layers with NH₄F/HCl solutions. A selective wet etching is achieved while the SiO₂ support layer is hardly attacked. The reached etching rate of SBT is 14 times higher than the etching rate of SiO₂. As previously mentioned, this method does not present the advantage of an anisotropic attack produced by the dry etching and leads again to a mask undercutting. This prior art doesn't contain any information about the SBT polymers removal, the SBT patterning process being a wet etch.

The invention primarily arose out of concerns and problems developed in the above mentioned prior art and not only overcomes the selectivity and the undercutting problems, but provides in addition, the advantage of a universal and simple cleaning method.

### Aims of the invention

The present invention aims to provide a universal "cleaning process" for patterned Aurelius type ferroelectric materials or layered ferroelectrics to remove all residues remaining from a dry etching process that uses various etching gas compositions.

Another purpose of the present invention is to provide a cleaning solution with a defined chemical composition for this cleaning process.

An additional aim of the present invention is to supply a cleaning solution for the showerheads used during de chemical vapour deposition of the SET layers or the Nb doped SET layers.

### Summary of the invention

The object of the present invention is to provide a reliable method for a residue removal after a dry etching of a SBT or Nb doped SBT ferroelectric materials.

A particular purpose of the present invention is to remove different types of residues created by different etching gas compositions. This purpose is achieved by an immersion and a rinsing step in a concentrated HCl solution (12mol/l) comprising a NH₄F salt.

Another objective of the invention is to define a range of concentrations wherein the immersion solution has only a cleaning effect and not the inconvenients of undercutting wet etching processes.

In the present invention, molar concentrations between 0.1 and 2 have been tested. Preferably, concentrations of NH₄F in HCl(12 mol/l) between 0.3 and 1.5 mol/l have been successfully used.

Particularly preferred concentrations between 0.6 and 0.8 mol/l NH₄F in HCl(12mol/l) is able to remove all the residues in a short period of time without undercutting the hard mask.

An additional key aspect of the present invention is that the efficiency of the cleaning solution is independent from the etching gas. That means that the cleaning solution has a large dissolving power spectrum and discloses herewith his universal aspect

A further surprising and unexpected advantage of this invention is the discovering of an optimal cleaning solution for the showerheads used during the chemical vapor deposition of the SBT layer

### Brief description of the drawings

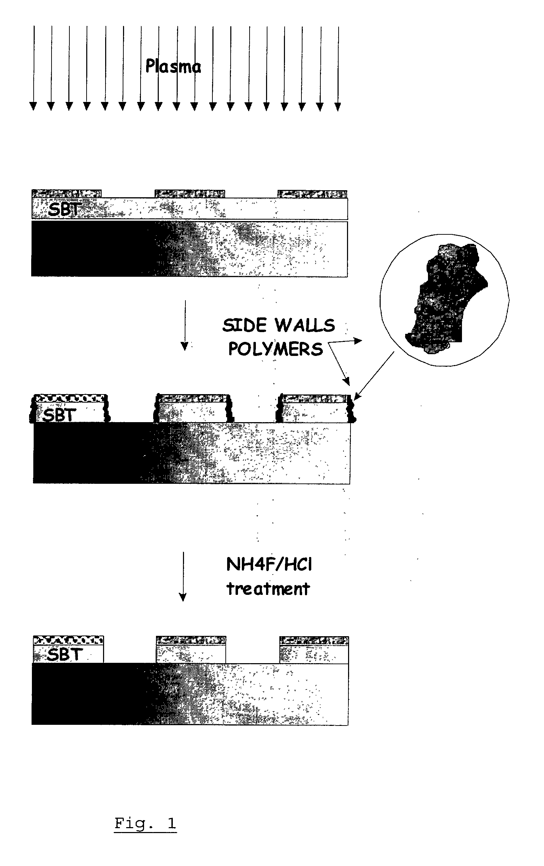

Figure 1 illustrates the remaining residues after the dry etching step.

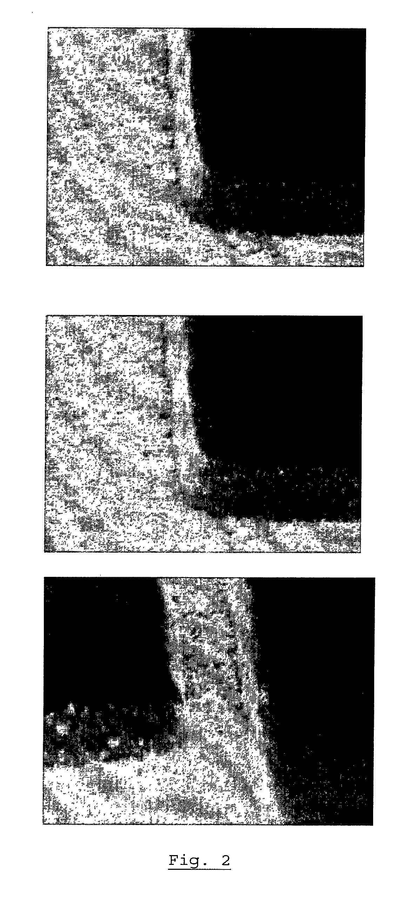

Figure 2 illustrates electronic microscope ferroelectric structures without the post etching cleaning

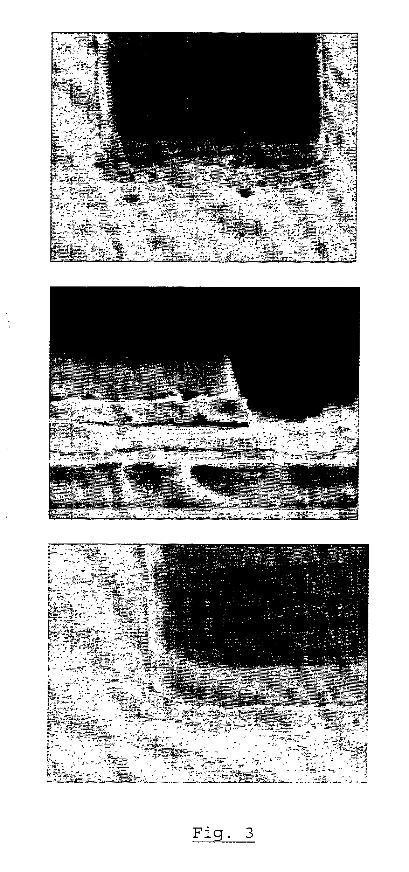

Figure 3 illustrates electronic microscope ferroelectric structures after post etch cleaning according to the invention.

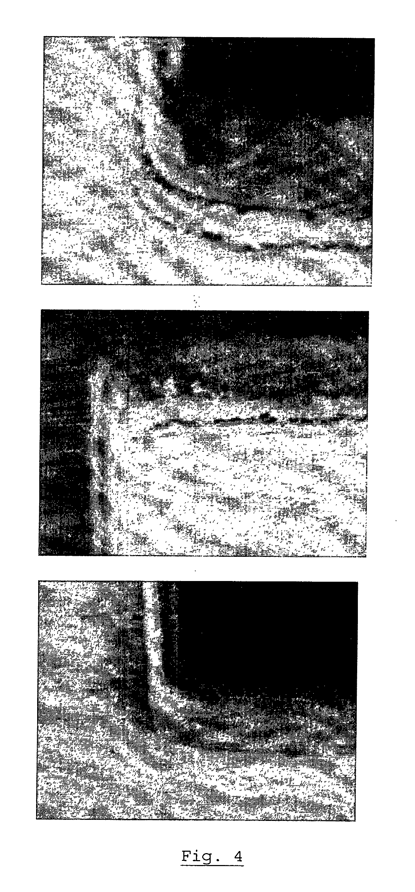

Figure 4 shows details of post etch cleaned element.

### Detailed description and preferred embodiment of the invention

The present invention describes a cleaning method of SBT or Nb doped SBT ferroelectric materials. Several embodiments are disclosed. It is apparent however that a person skilled in the art can imagine other equivalent embodiments or other ways of practising the present invention, the spirit and scope thereof being limited only by the claims.

As already mentioned in the introduction, there is a strong relation between the dry etching gas composition and the type of side wall residues which are produced. The present invention provides a method of removing those residues with a high selectivity towards the substrate and without undercutting the side walls.

Despite the selectivity of the cleaning solution, by a controlled attack of the side-wall polymers, it is particularly surprising that the cleaning method keeps a universal aspect, almost independent of the etching gas composition.

The residues are complex mixes of water-soluble salts of strontium, bismuth and tantalum chlorides and/or fluorides and non water-soluble strontium, bismuth and tantalum oxides, embedded in a matrix of carbon-fluorine polymers. Depending on the substrate, these residues can also contain complexes of Pt or Si. The complexity of these residues explains the difficulty to find a universal cleaning solution. The approach of the present invention teaches a cleaning solution without the inconvenients of wet etching isotropic mask undercutting.

The following samples have been etched with different etching gases and etching gas proportions. The exposure time has also been modified within the same etching gas mixture. The aim of these variations was the achieving of a large spectrum of residues. This was necessary to test the universality of the cleaning solution disclosed in this invention.

| **Samples** | **Etching gas mixtures** |
|---|---|
| Sample 1 | 50 Ar/5CF₄/10O₂ |
| Sample 2 | 40 Cl₂/40Ar/10O₂ |
| Sample 3 | 60Cl₂/10Ar/6CF₄/10O₂ during 73 seconds |
| Sample 4 | 60Cl₂/10Ar/6CF₄/10O₂ during 65 seconds |

The immersing solutions have been prepared by dissolving different quantities of NH₄F in a 36% HCl solution (12 mol/l). Concentrations between 0.1 and 2 moles/l of NH₄F in concentrated HCl have been tested. The immersion time is more or less proportional to the concentration of the solution and immersion times between 10 and 60 seconds, to solubilise the residues have been observed.

After the immersion treatment the samples have been thoroughly rinsed with water and dried under a slow nitrogen stream. It was particularly surprising to observe a good cleaning performance of the side walls on all the prepared samples with immersion times higher than 15 seconds

Additional cleaning experiments with cold and/or hot water have also been performed. The samples have been immersed for 10 minutes in cold water and/or 10 minutes in boiling water. None of these samples showed clean or promising results.

The unsuccessful water cleaning experiments proves that the residues are not simply water-soluble halogen mixtures of the SBT components.

Supplementary experiments shows that the cleaning solution has also good performance for the cleaning of the showerheads used during the chemical vapour SBT deposition.

While the invention has been illustrated by figures and described in what are considered to the most practical and preferred embodiments, it will be recognised that many variations are possible and come within the spirit and scope thereof, the appended claims therefore being entitled to a full range of equivalents.

## Claims

1. A method for residue removal after dry etching on a substrate coated with a ferroelectric material such as a SBT or Nb doped SBT material with an etch gas composition comprising an immersion in an HCl solution comprising at least a dissolved NH₄F salt and a rinsing step

2. A method as in claim 1, **characterised in that** the immersion solution has concentrations between 0.1 and 2 mol/l and more preferably between 0.3 and 1.5 mol/l of NH₄F in a concentrated HCl solution (12 mol/l)

3. A method as in claim 2, **characterised in that** the cleaning solution has most preferably concentrations between o.6 and 1 mol/l of NH₄F in a concentrated HCl solution (12 mol/l)

4. A method as in any one of the preceding claims, **characterised in that** the immersion time is situated between 10 and 60 seconds and more preferably between 15 and 45 seconds.

5. A method as in claim 1, **characterised in that** the cleaning solution has a large activity spectrum at temperatures between 10 and 50°C, and more preferably between 15 and 35 °C.

6. A method as in claim 1, **characterised in that** the cleaning efficiency is independent of an etch gas composition comprising Ar and /or CF₄ and/or O₂ and/or Cl₂

7. A method as in claim 2, **characterised in that** the cleaning solution is used for the cleaning of the showerheads used during the chemical vapor deposition of the SBT layers.
